# EUROPÄISCHE PATENTANMELDUNG

(11) **EP 2 639 848 A1**
(43) Veröffentlichungstag der Anmeldung: **18.09.2013**
(21) Anmeldenummer: 13158837.8
(22) Anmeldetag: 12.03.2013
(51) Int. Cl.: H01L 51/52

(54) **OLED-Kühlelement**

(30) Priorität: 13.03.2012 DE 102012203902
(71) Anmelder: Trilux GmbH & Co. KG, 59759 Arnsberg (DE)
(72) Erfinder: Rudolph, Horst, 59067 Hamm (DE); Ludwig, Sebastian, 50735 Köln (DE)
(74) Vertreter: Lippert, Stachow & Partner

(57) **Zusammenfassung**

Die Erfindung betrifft eine Anordnung (1) zum Erzeugen von Licht umfassend ein flächiges OLED-Element (2) mit einer Vorder- und einer Rückseite (3, 4), wobei an jeder der beiden Seiten (3, 4) flächige Elektroden (5, 6) angeordnet sind, von denen zumindest die an der Vorderseite (3) angeordnete transparent ist, wobei durch die Elektroden (5, 6) ein Strom erzeugbar ist, der zwischen den Elektroden (5, 6) flächig durch das OLED-Element (2) fließt, so dass das OLED-Element (2) Licht mit einer Lichtstärke emittiert, wobei das emittierte Licht zumindest an der Seite der Anordnung (1) aus der Anordnung (1) austritt, die der Vorderseite (3) des OLED-Elements (2) zugeordnet ist. Zur Verbesserung des Einflusses auf die Verteilung der Lichtstärkedichte über die emittierende Fläche des OLED-Elements beim Betrieb der Anordnung wird vorgeschlagen, dass an einer der Seiten (3, 4) des OLED-Elements (2), insbesondere an der Rückseite (4) des OLED-Elements (2) ein flächiger Kühlkörper (7) angeordnet ist, der eine vorbestimmte Kühlleistungsdichte aufweist, wobei die Kühlleistungsdichte mit einer auf Flächensegmente des Kühlkörpers (7) bezogenen Verteilung festgelegt ist.

## Beschreibung

Die Erfindung betrifft eine Anordnung zum Erzeugen von Licht umfassend ein flächiges OLED-Element nach dem Oberbegriff von Anspruch 1. Mit OLED-Element ist ein Element bezeichnet, das zumindest eine organische Leuchtdiode (OLED) aufweist.

In gattungsgemäßen Anordnungen wird Licht dadurch erzeugt, dass ein elektrischer Strom das OLED-Element flächig durchfließt. Hierzu umfassen gattungsgemäße Anordnungen zwei flächige Elektroden, wobei jeweils eine Elektrode an jeweils einer der beiden Seiten des flächigen OLED-Elements angeordnet ist. Die beiden Seiten stellen Vorder- und Rückseite des OLED-Elements dar. Ein das OLED-Element durchfließender Strom ist dadurch erzeugbar, dass zwischen den beiden flächigen Elektroden eine Spannung angelegt wird, so dass ein Strom das OLED-Element über seine gesamte Dicke durchfließt. Das OLED-Element ist dabei so ausgebildet, dass seine vertikale Erstreckung, die seine Dicke definiert, wesentlich kleiner ist als seine laterale und longitudinale Erstreckung, über die die flächige Erstreckung des OLED-Elements definiert ist. Üblicherweise weist das OLED-Element über seine gesamte Fläche hinweg eine identische Dicke auf.

In gattungsgemäßen Anordnungen ist zumindest die an der Vorderseite des OLED-Elements angeordnete flächige Elektrode transparent. Das in dem OLED-Element erzeugte Licht kann somit zumindest über die transparente Elektrode an der Vorderseite aus dem OLED-Element austreten und von der Anordnung abgestrahlt werden. Damit strahlt die Anordnung zumindest an der Seite Licht ab, die der Vorderseite des OLED-Elements zugeordnet ist. Je nach Ausgestaltung der Anordnung kann Licht auch an anderen Seiten als der der Vorderseite des OLED-Elements zugeordneten Seite, an der die transparente Elektrode angeordnet ist, aus der Anordnung austreten. Beispielsweise können hierzu optische Elemente wie Spiegel oder Linsen vorgesehen sein. Es sind jedoch auch Anordnungen bekannt, in denen auch die an der Rückseite angeordnete Elektrode transparent ist, so dass auch an der der Rückseite des OLED-Elements zugeordneten Seite der Anordnung Licht aus der Anordnung austritt. Da OLEDs von Feuchtigkeit angegriffen werden, umfassen herkömmliche Anordnungen häufig einen hüllenartigen Feuchtigkeitsschutz. Dieser ist häufig so ausgebildet, dass zwei Glasplatten flächig auf die an Vorder- und Rückseite angeordneten Elektroden aufgelegt und über einen das OLED-Element umlaufenden Dichtungskleber miteinander verbunden werden. Zur Erhöhung des Wirkungsgrads, d. h. zur Erhöhung der Lichtleistung, die die Anordnung bei Zuführung einer bestimmten elektrischen Energie emittiert, sind in herkömmlichen Anordnungen an zumindest einer Seite, an der die Anordnung Licht abstrahlt, mikrostrukturierte Folien oder zumindest eine mikrostrukturierte Folie angeordnet. Beispielsweise kann eine solche Folie durch Kleben mit einer das OLED-Element schützenden Glasplatte verbunden sein.

Gattungsgemäße Anordnungen sind flächige Lichtquellen und finden als solche vielfältigen Einsatz. Sie eignen sich beispielsweise für OP-Leuchten oder allgemein für eine gleichmäßige helle Ausleuchtung von Räumen. Der entscheidende Vorteil von OLED-Element basierten Anordnungen besteht darin, dass mit ihnen Leuchten mit einer sehr großen Leuchtfläche als Lichtquelle hergestellt werden können, wodurch sie sich von anderen üblichen Lichtquellen, wie etwa LEDs (herkömmliche Halbleiter-LEDs), Halogenstrahlern oder Hochdruckdampflampen erheblich abheben. Ein wesentliches Gütemerkmal herkömmlicher Anordnungen ist daher die Homogenität der Leuchtstärkedichte, mit der sie Licht an ihrer lichtemittierenden Seite bzw. ihren lichtemittierenden Seiten über die lichtemittierende Fläche abstrahlen. Gerade diese Homogenität der Lichtstärkedichte über die gesamte lichtemittierende Fläche ist bei gattungsgemäßen Anordnungen jedoch nur unbefriedigend und/oder unter Verlust an Lichtleistung, und damit an Wirkungsgrad, gewährleistet.

Für die Gewährleistung einer über die lichtemittierende Fläche homogenen Lichtstärkedichte hat sich insbesondere als problematisch herausgestellt, dass die an Vorder- und Rückseite des OLED-Elements angeordneten Elektroden einen elektrischen Widerstand aufweisen. Dies trifft insbesondere für transparente Elektroden, wie beispielsweise ITO-Elektroden, zu. Naturgemäß wird eine transparente Elektrode, die an einer Seite des OLED-Elements angeordnet ist, die der lichtabstrahlenden Seite der Anordnung zugeordnet ist, nur von ihrem Rand mit Strom gespeist, damit so elektrische Kontakte auf der flächigen Elektrode vermieden werden können, die eine Reduktion der Lichtausbeute zur Folge hätten. Wenn somit ein Strom von den an Vorder- und Rückseite des OLED-Elements angeordneten Elektroden in dem OLED-Element erzeugt wird und durch das OLED-Element fließt, dann liegt in der Flächenmitte des OLED-Elements zwischen den flächigen Elektroden eine niedrigere Spannung an als in Randbereichen des OLED-Elements, da über die Strecke zwischen dem Rand der flächigen Elektroden und der Mitte des OLED-Elements über den spezifischen Widerstand des Elektrodenmaterials eine zur Stromstärke des fließenden Stroms im Wesentlichen proportionale Spannung abfällt. Da in der Mitte des flächigen OLED-Elements eine geringere Spannung anliegt als an seinem Rand, leuchtet das flächige OLED-Element in den Randbereichen stärker als in der Mitte. Die Lichtstärkedichte des von dem OLED-Element emittierten Lichts ist somit nicht über die gesamte lichtemittierende Fläche homogen, sondern das von dem OLED-Element emittierte Licht weist eine Verteilung der Lichtstärkedichte über die Fläche des OLED-Elements auf, wobei die Lichtstärkedichte in Flächensegmenten des OLED-Elements, die von dem nächstliegenden elektrischen Einspeisekontakt weiter entfernt sind, niedriger ist als in solchen Flächensegmenten, die nahe an elektrischen Einspeisekontakten liegen.

In herkömmlichen Anordnungen wird diesem Problem zumeist dadurch Rechnung getragen, dass auf die Elektroden, insbesondere auf die transparenten Elektroden eine gitterförmige Struktur von zumeist metallischen Leitern mit sehr niedrigem spezifischem Widerstand aufgebracht wird (sogenannte Busbars), über die Strom in die Elektroden eingespeist wird. Diese Gitterstrukturen sind jedoch nicht lichtdurchlässig. Die Fläche der effektiven transparenten Elektroden ist somit durch die Größe der Gitterstruktur festgelegt, nämlich durch die Flächen der Gitterzellen, die durch die Gitterstruktur der Leiter gebildet werden. Dadurch können so kleine transparente Elektroden realisiert werden, dass der Spannungsverlust über die gesamte Fläche der Elektroden wegen des elektrischen Widerstands des Elektrodenmaterials so gering ist, dass die Lichtstärkedichte über die Elektrode homogen ist. Allerdings bringt diese Maßnahme den Nachteil mit sich, dass durch die nicht transparente Gitterstruktur die Lichtausbeute verringert wird. Darüber hinaus ist die Gitterstruktur für einen Betrachter der Anordnungen sichtbar, während die Anordnungen Licht emittieren. Dies ist ein ungewünschter optischer Effekt.

Darüber hinaus kann in herkömmlichen Anordnungen nur unzureichend Einfluss auf die Verteilung der Lichtstärkedichte über die emittierende Fläche des OLED-Elements beim Betrieb der Anordnung genommen werden. So lassen sich beispielsweise nur unzureichend Verteilungen realisieren, mit denen bewusst vorbestimmte hellere und dunklere mit jeweils höherer bzw. niedrigerer Lichtstärkedichte in der lichtemittierenden Fläche des OLED-Elements in der Anordnung vorgegeben sind und somit die Verteilung der Lichtstärkedichte der Anordnung entsprechend festgelegt ist.

Ausgehend von dem Stand der Technik liegt der Erfindung die Aufgabe zugrunde, eine Anordnung zum Erzeugen von Licht umfassend ein flächiges OLED-Element bereitzustellen, durch die die obenbeschriebenen Probleme herkömmlicher Anordnungen zumindest teilweise behoben werden.

Als eine Lösung der genannten technischen Aufgabe schlägt die Erfindung eine Anordnung mit den Merkmalen von Anspruch 1 vor.

Die erfindungsgemäße Anordnung zeichnet sich dadurch aus, dass an einer der Seiten des OLED-Elements, insbesondere an der Rückseite des OLED-Elements ein flächiger Kühlkörper angeordnet ist, der eine vorbestimmte Kühlleistungsdichte aufweist, wobei die Kühlleistungsdichte mit einer auf Flächensegmente des Kühlkörpers bezogenen Verteilung festgelegt ist. Die Kühlleistungsdichte bezeichnet dabei die Kühlleistung des Kühlkörpers pro Flächeneinheit. Die Fläche des Kühlkörpers ist über seine laterale und longitudinale Erstreckung festgelegt und in Flächensegmente eingeteilt. In einem Flächensegment weist der Kühlkörper eine bestimmte Kühlleistungsdichte auf, die über das Flächensegment im Wesentlichen konstant ist. In erfindungsgemäßen Anordnungen ist die Kühlleistungsdichte des Kühlkörpers für jedes Flächensegment festgelegt. Die Fläche des Kühlkörpers erstreckt sich zumindest über einen wesentlichen Teil der flächigen Erstreckung des OLED-Elements. Vorteilhafterweise kann die dem OLED-Element zugewandte Oberfläche des Kühlkörpers eben sein. Insbesondere kann diese Oberfläche des Kühlkörpers eine Ebene definieren, die im Wesentlichen parallel zu der Ebene ist, die die Oberfläche des OLED-Elements, die dem Kühlkörper zugewandt ist, definiert. Insbesondere kann der Kühlkörper über einen wesentlichen Teil der flächigen Erstreckung des OLED-Elements flächig an dem OLED-Element oder der zwischen ihm und dem OLED-Element angeordneten Elektrode anliegen. Insbesondere kann der Kühlkörper die an der Rückseite angeordnete Elektrode umfassen.

Die Fläche des Kühlkörpers kann in ein oder mehrere Flächensegmente aufgeteilt sein. Die Größe der Flächensegmente kann dabei zwischen den Flächensegmenten einer Aufteilung variieren. Beispielsweise kann die Gesamtfläche des Kühlkörpers in eine beliebige Anzahl gleich großer Flächensegmente aufgeteilt sein. Die Fläche des Kühlkörpers kann auch in eine so große Anzahl an Flächensegmenten aufgeteilt sein, dass die Verteilung der Kühlleistungsdichte stufenlos ist, da die Größe der Flächensegmente annähernd infinitesimal klein ist.

Die auf die Flächensegmente des Kühlkörpers bezogene Verteilung der Kühlleistungsdichte kann beispielsweise so festgelegt sein, dass der Kühlkörper in jedem Flächensegment eine jeweils unterschiedliche Kühlleistungsdichte aufweist. Auch kann die Kühlleistungsdichte in einigen der Flächensegmente identisch sein. Insbesondere kann die Verteilung der Kühlleistungsdichte einem auf die Flächensegmente bezogenen funktionalen Zusammenhang folgen. So kann beispielweise einem jedem Flächensegment ein Mittelpunkt zugeordnet werden, der über X, Y-Koordinaten der Fläche des Kühlkörpers eindeutig festlegbar ist. Beispielsweise kann die Kühlleistungsdichte der Flächensegmente in Abhängigkeit von dem Abstand des Mittelpunkts des jeweiligen Flächensegments von dem Mittelpunkt der Fläche des Kühlkörpers oder des zugeordneten OLED-Elements festgelegt sein. Beispielsweise kann die Kühlleistungsdichte in den Flächensegmenten so festgelegt sein, dass sie linear oder in anderer funktionaler Abhängigkeit mit dem Abstand des Mittelpunkts eines Flächensegments von dem Mittelpunkt der Fläche des OLED-Elements zunimmt.

Die erfindungsgemäße Anordnung zeichnet sich somit durch einen Kühlkörper aus, der über seine flächige Erstreckung eine vorgegebene Verteilung der Kühlleistungsdichte aufweist. Der Kühlkörper ist so an dem OLED-Element angeordnet, dass er dieses kühlt. Dabei muss der Kühlkörper nicht zwingend direkt an dem OLED-Element anliegen. Dadurch wird das OLED-Element so gekühlt, dass es über seine flächige Erstreckung zumindest an den Stellen, an denen sich der Kühlkörper flächig über das OLED-Element erstreckt, eine vorbestimmte Temperaturverteilung aufweist. Diese Temperaturverteilung ist, entsprechend der Verteilung der Kühlleistungsdichte des Kühlkörpers, auf Flächensegmente bezogen festgelegt.

Die Lichtstärkedichte, die ein OLED-Element in einem Flächensegment emittiert, ist bei einer vorgegebenen angelegten Spannung zur Erzeugung von Licht in dem OLED-Element von der Temperatur des OLED-Elements in diesem Flächensegment abhängig. Dabei ist zu berücksichtigen, dass eine jede OLED, die einen bestimmten Aufbau aufweist, bei Anlegen einer vorgegebenen Spannung zur Erzeugung von Licht ein definiertes, messbares Temperatur-Lichtstärke-Verhalten aufweist. Ein flächiges OLED-Element weist ein über seine flächige Erstreckung konstantes Temperatur-Lichtstärke-Verhalten auf. Dadurch, dass in der erfindungsgemäßen Anordnung über den flächigen Kühlkörper, der das OLED-Element kühlt und dessen Kühlleistungsdichte eine auf Flächensegmente des Kühlkörpers bezogene Verteilung aufweist, die Temperaturverteilung des OLED-Elements bezogen auf Flächensegmente festlegbar ist, lässt sich über den Kühlkörper bei einer nach Flächensegmenten bekannten angelegten Spannung an dem OLED-Element die Lichtstärkedichte nach Flächensegmenten festlegen.

Die Verteilung der Lichtstärkedichte des von der Anordnung abgestrahlten Lichts ist somit sowohl von der Verteilung der Kühlleistungsdichte als auch von der natürlichen Verteilung der Lichtstärkedichte des von dem OLED-Element emittierten Lichts, das das OLED-Element in der Anordnung ohne das Vorsehen eines Kühlkörpers emittieren würde, abhängig. Diese natürliche Verteilung der Lichtstärkedichte des von dem OLED-Element emittierten Lichts lässt sich beispielsweise berechnen oder anhand von Vormessungen an OLED-Elementen in vergleichbaren Anordnungen, d.h. Anordnungen mit zumindest dem gleichen Aufbau von Elektroden, Stromeinspeisekontakten und OLED-Element, ohne Kühlkörper ermitteln. Die natürliche Verteilung lässt sich auch anhand von Messungen der Verteilung der Lichtstärkedichte des von dem OLED-Element in einer bestimmten Messanordnung emittierten Lichts und bei Kenntnis der elektrischen Konfiguration der Messanordnung und der erfindungsgemäßen Anordnung, in der das OLED-Element angeordnet werden soll, ermitteln, beispielsweise über die elektrischen und gemessenen Kenndaten berechnen.

Die erfindungsgemäße Ausgestaltung der Anordnung erlaubt somit, die Verteilung der Lichtstärkedichte nach Flächensegmenten des OLED-Elements, und damit die Verteilung der von der Anordnung abgestrahlten Lichtstärkedichte sehr einfach festzulegen oder zumindest zu beeinflussen. Beispielsweise kann über die an den Einspeisekontakten angelegte Spannung, den fließenden Strom und den elektrischen Widerstand der Elektroden der Anordnung berechnet oder abgeschätzt werden, welche Spannung in welchem Flächensegment des OLED-Elements zur Erzeugung von Licht anliegt. Mit dem Einstellen einer bestimmten Kühlleistungsdichte in dem Flächensegment zur Erzeugung einer bestimmten Temperatur in dem Flächensegment des OLED-Elements kann dann die Lichtstärkedichte für jedes Flächensegment festgelegt werden. Dadurch kann beispielsweise in der erfindungsgemäßen Anordnung eine sehr homogene Verteilung der Lichtstärkedichte über die gesamte lichtemittierende flächige Erstreckung des OLED-Elements gewährleistet sein. Auch können dadurch beispielsweise flächige Zonen festgelegt werden, die im Vergleich zu anderen Zonen des OLED-Elements besonders hell leuchten.

Je nach Aufbau des OLED-Elements kann ausgehend von einer bestimmten Umgebungstemperatur die von dem OLED-Element bei Anliegen einer bestimmten Spannung erzeugte Lichtstärke bei Kühlung des OLED-Elements, d. h. bei Absenken der Temperatur unterhalb der Umgebungstemperatur, sinken oder steigen. Dabei kann als Umgebungstemperatur auch die Temperatur definiert sein, die das OLED-Element in einem bestimmten Betriebszustand in einer Umgebung mit einer bestimmten Temperatur hat, seine Erwärmung in diesem Betriebszustand kann also berücksichtigt sein. Wenn die Umgebungstemperatur bekannt ist, in der eine erfindungsgemäße Anordnung eingesetzt werden soll, in der ein OLED-Element mit bekanntem Aufbau und bekanntem Temperatur-Lichtstärke-Verhalten angeordnet ist, dann kann beispielsweise alleine über die Verteilung der Kühlleistungsdichte die Verteilung der Lichtstärkedichte des von der Anordnung emittierten Lichts festgelegt oder angenähert werden. Im Vergleich zu herkömmlichen Anordnungen lässt sich somit beispielsweise durch eine erfindungsgemäße Anordnung eine über ihre flächige Erstreckung homogen emittierende großflächige Lichtquelle erzeugen, ohne dass herkömmliche Busbars erforderlich sind, die die Lichtausbeute verringern und unerwünschte optische Effekte mit sich bringen.

Vorteilhafterweise ist der Kühlkörper an der Vorderseite angeordnet und transparent. Der Kühlkörper kann auch an der Rückseite angeordnet sein, so dass er die Abstrahlung von Licht möglichst wenig behindert.

Vorteilhafterweise kann der Kühlkörper an der Rückseite angeordnet sein, wobei die die an der Rückseite der Anordnung angeordnete Elektrode und der Kühlkörper transparent sind. Dadurch kann die erfindungsgemäße Anordnung sowohl an der der Vorderseite des OLED-Elements zugeordneten Seite als auch an der der Rückseite des OLED-Elements zugeordneten Seite Licht abstrahlen, ohne dass zusätzliche optische Elemente, wie beispielsweise Spiegel, notwendig sind.

Insbesondere kann an der Vorderseite des OLED-Elements ein zweiter transparenter Kühlkörper angeordnet sein. Dadurch kann in der Anordnung die Temperaturverteilung nach Flächensegmenten in dem OLED-Element besonders präzise festgelegt sein, insbesondere bei bekannter Umgebungstemperatur. Darüber hinaus beeinträchtigt der transparente zweite Kühlkörper nicht oder nur unwesentlich die Abstrahlung von Licht von der Vorderseite des OLED-Elements weg. Dadurch kann weiterhin eine hohe Lichtausbeute für das von der Anordnung emittierte Licht bei einem vorgegebenen Strom zur Erzeugung des Lichts gewährleistet sein.

Vorteilhafterweise kann die Verteilung der

Kühlleistungsdichte zumindest eines der Kühlkörper so festgelegt sein, dass die Kühlleistungsdichte in Flächensegmenten in und/oder nahe der Flächenmitte des OLED-Elements höher ist als in Flächensegmenten am Rand des OLED-Elements. Wird beispielsweise in der erfindungsgemäßen Anordnung ein OLED-Element eingesetzt, das ein solches Temperatur-Lichtstärke-Verhalten aufweist, dass die von ihm emittierte Lichtstärke bei einem Absenken seiner Temperatur unter die Umgebungstemperatur größer ist als bei Umgebungstemperatur, so kann sich mit einer solchen erfindungsgemäßen Anordnung bei dem Vorsehen einer über die gesamte flächige Erstreckung konstanten an dem OLED-Element anliegenden Spannung eine solche Verteilung der Lichtstärkedichte über die emittierende Fläche des OLED-Elements erzeugen lassen, dass die Lichtstärkedichte in der Mitte des OLED-Elements höher ist als am Rand des OLED-Elements. Falls ein solches OLED-Element mit dem genannten Temperatur-Lichtstärke-Verhalten in einer erfindungsgemäßen Anordnung angeordnet ist, bei der die an dem OLED-Element anliegende Spannung in der Mitte des OLED-Elements niedriger ist als in seinem Rand, dann kann eine über die gesamte lichtemittierende Fläche des OLED-Elements konstante Lichtstärkedichte gewährleistet sein.

Insbesondere ist es auch möglich, dass die Verteilung der Kühlleistungsdichte nach Flächensegmenten so festgelegt ist, dass die Kühlleistungsdichte vom Rand des OLED-Elements in Richtung zur Mitte des OLED-Elements zumindest abschnittsweise kontinuierlich und/oder gleitend ansteigt. Dadurch kann beispielsweise einem kontinuierlichen und/oder gleitenden Abfallen der anliegenden Spannung von dem Rand zur Mitte des OLED-Elements hin dergestalt entgegengewirkt werden, dass eine homogene Verteilung der Lichtstärkedichte des von der Anordnung abgestrahlten Lichts gewährleistet ist. Die beschriebenen Ausführungen sind auch für erfindungsgemäße Anordnungen anwendbar, in denen ein OLED-Element angeordnet ist, das ein solches Temperatur-Lichtstärke-Verhalten aufweist, dass es bei einem Absenken seiner Temperatur unter die Umgebungstemperatur eine geringere Lichtstärke als bei Umgebungstemperatur emittiert. Beispielsweise kann sich dadurch bei der Ausgestaltung der erfindungsgemäßen Anordnung nach der beschriebenen Ausführungsform eine Anordnung realisieren lassen, die in der Mitte ihrer lichtemittierenden Flächen eine geringere Lichtstärkedichte aufweist als am Rand.

In einer weiteren vorteilhaften Ausführungsform ist die Verteilung der Kühlleistungsdichte zumindest eines der Kühlkörper so festgelegt, dass die Kühlleistungsdichte in Flächensegmenten in und/oder nahe der Flächenmitte des OLED-Elements niedriger ist als in Flächensegmenten am Rand des OLED-Elements. Falls in einer solchen erfindungsgemäßen Anwendung ein OLED-Element angeordnet ist, das ein solches Temperatur-Lichtstärke-Verhalten aufweist, dass es bei einem Absenken der Temperatur unter die Umgebungstemperatur eine geringere Lichtstärke emittiert als bei Umgebungstemperatur, dann kann bei der entsprechenden erfindungsgemäßen Ausgestaltung eine Anordnung realisiert werden, die in der Mitte ihrer lichtemittierenden Fläche eine stärkere Lichtstärkedichte aufweist als am Rand, wenn eine über die gesamte lichtemittierende Fläche konstante Spannung angelegt ist. Falls die an dem OLED-Element anliegende Spannung am Rand des OLED-Elements höher ist als in der Mitte, beispielsweise durch Spannungsverlust wegen des Widerstands des Elektrodenmaterials und dem fließenden Strom, dann kann mit der erfindungsgemäßen Ausgestaltung der Anordnung, in der ein solches OLED-Element mit dem genannten Temperatur-Lichtstärke-Verhalten angeordnet ist, eine homogene Verteilung der Lichtstärkedichte über die gesamte lichtemittierende Fläche der Anordnung gewährleistet sein. Im Übrigen sind die Ausführungen zu dem in dem vorigen Absatz erläuterten Ausführungsbeispiel auf dieses Ausführungsbeispiel entsprechend anwendbar.

Weiterhin kann die Verteilung der Kühlleistungsdichte zumindest eines der Kühlkörper in Abhängigkeit von der auf Flächensegmente des OLED-Elements bezogenen natürlichen Verteilung der Lichtstärkedichte des von dem OLED-Element emittierten Licht festgelegt sein, wobei ein Flächensegment des Kühlkörpers jeweils einem Flächensegment des OLED-Elements zugeordnet ist. Wie oben erläutert bezieht sich der Begriff der natürlichen Verteilung der Lichtstärkedichte des von dem OLED-Element emittierten Lichts auf die Verteilung, die das OLED-Element in einer entsprechenden Anordnung ohne das Vorsehen eines Kühlkörpers emittieren würde.

Bei dieser Ausführungsform ist eine besonders gute Einstellung der Verteilung der Lichtstärkedichte des von der Anordnung emittierten Lichts möglich. Die Verteilung der Lichtstärkedichte des OLED-Elements bezogen auf seine Flächensegmente kann beispielsweise an dem OLED-Element der Anordnung direkt gemessen werden, beispielsweise bei einem Anordnen des OLED-Elements in einer entsprechenden Anordnung ohne Kühlkörper. Die Verteilung der Lichtstärkedichte kann beispielsweise auch abgeschätzt oder berechnet werden, z.B. auf der Basis von Messungen an der Anordnung mit dem OLED-Element bei bekannter Verteilung der Kühlleistungsdichte des Kühlkörpers der Anordnung. Die Fläche des an dem OLED-Element angeordneten Kühlkörpers ist in Flächensegmente eingeteilt, wobei jeweils ein Flächensegment des Kühlkörpers einem Flächensegment des OLED-Elements zugeordnet ist. Beispielsweise können die Flächensegmente von Kühlkörper und OLED-Element kongruent zueinander angeordnet sein.

Die Verteilung der Kühlleistungsdichte ist in Abhängigkeit von der natürlichen Verteilung der Lichtstärkedichte des OLED-Elements festgelegt, so dass eine sehr präzise Festlegung der Verteilung der Lichtstärkedichte des von der Anordnung emittierten Lichts möglich ist. Beispielsweise kann zwischen Kühlleistungsdichte und natürlicher Lichtstärkedichte des OLED-Elements ein funktionaler Zusammenhang festgelegt sein. Beispielsweise kann die Kühlleistungsdichte für ein Flächensegment des Kühlkörpers auf einen bestimmten Wert festgelegt sein, wenn der Wert der natürlichen Lichtstärkedichte in dem zugeordneten Flächensegment des OLED-Elements in einem festgelegten Intervall liegt. Beispielsweise ist es auch möglich, eine nominale Lichtstärkedichte vorzugeben und die prozentuale Abweichung der emittierten natürlichen Lichtstärkedichte in einem Flächensegment von der nominalen Lichtstärkedichte anzugeben. Die Kühlleistungsdichte kann dann beispielsweise bezogen auf eine nominale Kühlleistungsdichte in jedem einem entsprechenden Flächensegment des OLED-Elements zugeordneten Flächensegmente des Kühlkörpers entsprechend prozentual variiert sein. Insbesondere ist es auch möglich, bei einer entsprechenden erfindungsgemäßen Ausführungsform die natürliche Verteilung der Lichtstärkedichte des OLED-Elements nach einer Alterung des OLED-Elements erneut zu bestimmen und die Verteilung der Kühlleistungsdichte des Kühlkörpers neu anzupassen, beispielsweise durch Austausch des Kühlkörpers oder Abänderung des Kühlkörpers. So kann mit einer erfindungsgemäßen Anordnung über eine lange Lebensdauer hinweg eine bestimmte Verteilung der von der Anordnung emittierten Lichtstärkedichte gewährleistet sein, beispielsweise eine homogene Verteilung der Lichtstärkedichte.

Vorteilhafterweise kann die Verteilung der Kühlleistungsdichte des Kühlkörpers invertiert zu der natürlichen Verteilung der Lichtstärkedichte des OLED-Elements festgelegt sein. Hierbei ist die Kühlleistungsdichte in Flächensegmenten des Kühlkörpers, die Flächensegmenten des OLED-Elements zugeordnet sind, in denen das OLED-Element Licht mit einer relativ geringen Lichtstärkedichte emittiert, höher als in solchen Flächensegmenten, die Flächensegmenten des OLED-Elements zugeordnet sind, in denen das OLED-Element eine relativ hohe Lichtstärkedichte emittiert. Eine solche vorteilhafte Ausführungsform ist beispielsweise für erfindungsgemäße Anordnungen vorteilhaft, die OLED-Elemente umfasst, die ein solches Temperatur-Lichtstärkedichte-Verhalten aufweisen, dass sie bei einer Absenkung ihrer Temperatur unter die Umgebungstemperatur eine höhere Lichtstärkedichte emittieren. Solche erfindungsgemäße Anordnungen können nach dem genannten Ausführungsbeispiel eine homogene Verteilung der Lichtstärkedichte des ausgestrahlten Lichts aufweisen.

Vorteilhafterweise kann die Verteilung der Kühlleistungsdichte des Kühlkörpers direkt korrelierend zu der natürlichen Verteilung der Lichtstärkedichte des OLED-Elements festgelegt sein. Demnach ist die Kühlleistungsdichte in Flächensegmenten des Kühlkörpers höher, die Flächensegmenten des OLED-Elements zugeordnet sind, in denen das OLED-Element Licht mit einer relativ hohen Lichtstärkedichte emittiert, als in solchen Flächensegmenten des Kühlkörpers, die Flächensegmenten des OLED-Elements zugeordnet sind, in denen das OLED-Element mit relativ niedriger Lichtstärkedichte emittiert. Damit kann insbesondere bei Anordnungen, die OLED-Elemente umfassen, die bei einer Absenkung ihrer Temperatur unter die Umgebungstemperatur mit einer höheren Lichtstärkedichte emittieren, eine homogene Verteilung der Lichtstärkedichte des von der Anordnung abgestrahlten Lichts gewährleistet sein.

Insbesondere kann eine erfindungsgemäße Anordnung eine Steuerung umfassen, die die Verteilung der Kühlleistungsdichte des Kühlkörpers steuert. Die Steuerung kann beispielsweise unter Berücksichtigung des Temperatur-Lichtstärke-Verhaltens des OLED-Elements in Abhängigkeit von der Umgebungstemperatur erfolgen und/oder in Abhängigkeit von einer gemessenen Verteilung der Lichtstärkedichte des von der Anordnung emittierten Lichts. Dadurch kann beispielsweise auch bei einer Variation der Umgebungsbedingungen, in denen die erfindungsgemäße Anordnung eingesetzt ist, eine homogene Verteilung der von der Anordnung emittierten Lichtstärkeverteilung gewährleistet sein.

In einer weiteren vorteilhaften Ausführungsform ist die Kühlleistungsdichte des Kühlkörpers durch die Dicke des flächigen Kühlkörpers festgelegt. Dies kann durch die Wahl des Materials, aus dem der Kühlkörper hergestellt ist, realisiert sein. Beispielsweise kann der Kühlkörper so vorgesehen sein, dass seine Kühlleistungsdichte in Flächensegmenten, in denen der Kühlkörper dünner ist, niedriger ist als in solchen Flächensegmenten, in denen der Kühlkörper dicker ist. Durch das Vorsehen eines entsprechenden Kühlkörpers kann allein über die Variation der Dicke des Kühlkörpers die Verteilung der Kühlleistungsdichte des Kühlkörpers festgelegt sein. Entsprechend ist durch einfaches Modellieren des Kühlkörpers eine entsprechende Verteilung realisierbar. Beispielsweise kann ein solcher Kühlkörper nach einer bestimmten Dickenverteilung geschliffen oder gegossen werden.

Die Erfindung umfasst weiterhin eine Leuchte umfassend eine wie obenbeschriebene erfindungsgemäße Anordnung. Eine solche Leuchte kann beispielsweise zusätzlich ein Gehäuse und elektrische Verkabelung umfassen. Eine erfindungsgemäße Leuchte kann in Räumen zur Bereitstellung einer großflächigen Leuchte mit einer vorgegebenen, insbesondere homogenen Verteilung der Lichtstärkedichte über ihre flächige Erstreckung geeignet sein.

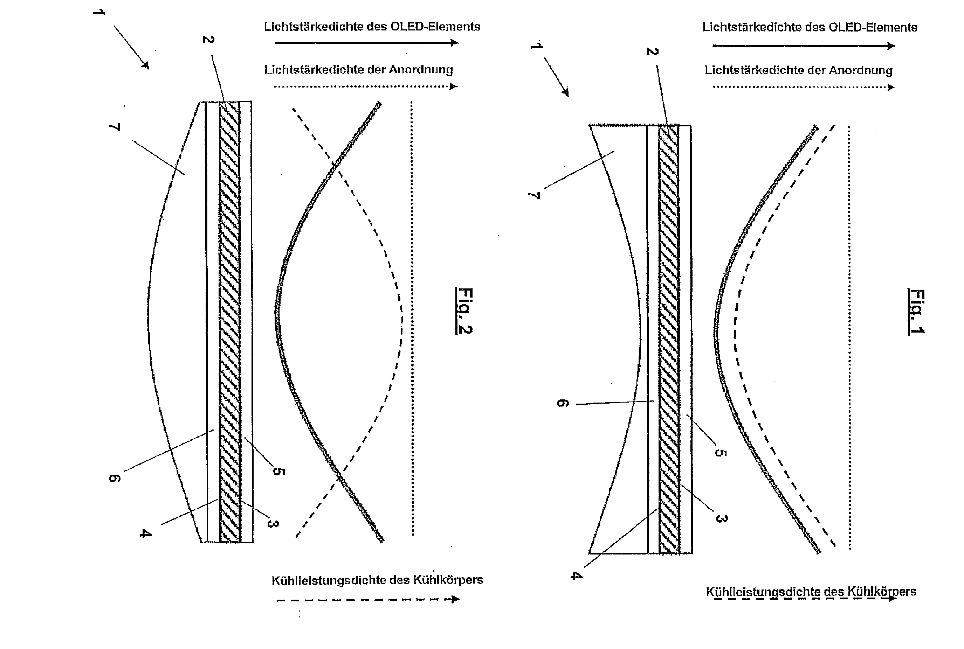

Die Erfindung wird im Folgenden durch das Beschreiben von zwei Ausführungsformen unter Bezugnahme auf die beiliegenden Figuren 1 und 2 weiter erläutert.

Es zeigt
- Figur 1:: eine schematische Schnittdarstellung einer Ausführungsform einer erfindungsgemäßen Anordnung;
- Figur 2:: eine schematische Schnittdarstellung einer weiteren Ausführungsform einer erfindungsgemäßen Anordnung.

Figur 1 zeigt eine Schnittdarstellung einer Ausführungsform einer erfindungsgemäßen Anordnung 1. Die erfindungsgemäße Anordnung 1 umfasst ein OLED-Element 2 mit einer Vorderseite 3 und einer Rückseite 4. An der Vorderseite 3 des OLED-Elements 2 ist eine transparente erste Elektrode 5 angeordnet. An der Rückseite 4 des OLED-Elements 2 ist eine nicht transparente, metallische zweite Elektrode 6 angeordnet. Erste Elektrode 5 und zweite Elektrode 6 liegen jeweils flächig an dem OLED-Element 2 an. Weiterhin umfasst die erfindungsgemäße Anordnung 1 einen Kühlkörper 7. Die zum OLED-Element 2 gewandte Oberfläche des Kühlkörpers 7 ist eben, wobei die Ebene, die durch diese Oberfläche des Kühlkörpers 7 definiert ist, parallel zu der Ebene ist, die durch die Oberfläche der zweiten Elektrode 6 definiert ist, die zu dem Kühlkörper 7 gewandt ist. Der Kühlkörper 7 liegt flächig an der zweiten Elektrode 6 an. Zwischen dem Kühlkörper 7 und dem OLED-Element 2 besteht eine sehr gute Wärmeleitung. Damit kann der Kühlkörper 7 effektiv eine Kühlung des OLED-Elements 2 bewirken. Durch die gute Wärmeleitung zwischen dem Kühlkörper 7 und dem OLED-Element 2 ist weiterhin sichergestellt, dass eine Verteilung der Kühlleistungsdichte des Kühlkörpers 7 nach Flächensegmenten eine Temperaturverteilung nach Flächensegmenten in dem OLED-Element 2 erzeugt.

Die Kühlleistungsdichte des Kühlkörpers 7 ist über die Dicke des Kühlkörpers 7 festgelegt. In dem in Figur 1 dargestellten Schnitt sind nur die lateralen und vertikalen Erstreckungen der Anordnung dargestellt. Die Dicke des Kühlkörpers 7 ist über seine vertikale Erstreckung definiert.

In dem in Figur 1 dargestellten Ausführungsbeispiel tritt das von dem OLED-Element emittierte Licht nur an der der Vorderseite 3 des OLED-Elements 2 zugeordneten Seite der Anordnung 1 aus der Anordnung aus. In Figur 1 ist der Verlauf der natürlichen Lichtstärkedichte des von dem OLED-Element emittierten Lichts mit einer durchgezogenen Linie und der Verlauf der Kühlleistungsdichte des Kühlkörpers mit einer gestrichelten Linie entlang des Schnitts dargestellt. Aus Figur 1 ist zu entnehmen, dass die Lichtstärkedichte und die Kühlleistungsdichte jeweils am Rand des OLED-Elements 2 höher sind als in der Mitte des OLED-Elements 2. Die Verteilung der Kühlleistungsdichte und die Verteilung der Lichtstärkedichte des OLED-Elements 2 gehorchen dabei entlang des Schnitts dergestalt demselben funktionalen Zusammenhang, dass die Verteilung der Kühlleistungsdichte des Kühlkörpers 7 direkt korrelierend zu der natürlichen Verteilung der Lichtstärkedichte des OLED-Elements 2 festgelegt ist. In dem dargestellten Ausführungsbeispiel umfasst die Anordnung ein OLED-Element 2, das bei einem Absenken seiner Temperatur unter die Umgebungstemperatur weniger Licht emittiert als bei Umgebungstemperatur. Als Umgebungstemperatur ist dabei die Temperatur bezeichnet, die das OLED-Element in einem bestimmten Betriebszustand bei einem Betrieb in einer Umgebung mit bestimmter Temperatur hat. Die Erwärmung des OLED-Elements beim Betrieb ist somit berücksichtigt. Dadurch ist in dem dargestellten Ausführungsbeispiel die zu dem Rand hin zunehmende Lichtstärkedichte des OLED-Elements durch die zum Rand hin zunehmende Kühlleistungsdichte des Kühlkörpers 7 kompensiert, so dass die Anordnung 1 über ihre gesamte laterale Erstreckung hinweg Licht mit einer konstanten Lichtstärkedichte emittiert. Die natürliche Verteilung der Lichtstärkedichte des OLED-Elements 2 ist in Figur 1 mit einer durchgezogenen Linie dargestellt, die Verteilung der Lichtstärkedichte der Anordnung 1 durch eine punktierte Linie und die Verteilung der Kühlleistungsdichte des Kühlkörpers 7 durch eine gestrichelte Linie. Aus Figur 1 wird ersichtlich, dass mit der erfindungsgemäßen Anordnung 1 eine homogene Verteilung der Lichtstärkedichte des von der Anordnung 1 emittierten Lichts über die gesamte flächige Erstreckung der Anordnung 1 realisierbar ist, indem die Verteilung der Kühlleistungsdichte des Kühlkörpers 7 in Abhängigkeit von der Verteilung der Lichtstärkedichte des OLED-Elements 2 festgelegt ist. Die Verteilung erfolgt jeweils bezogen auf Flächensegmente des OLED-Elements 2 bzw. des Kühlkörpers 7. Ein Schnitt der Flächensegmente ist in Figur 1 nicht dargestellt. Die Flächensegmente können in beliebiger Größe und Anzahl gewählt werden. In dem dargestellten Ausführungsbeispiel sind die Flächensegmente so klein gewählt, dass auch eine Realisierung von einer stufenfreien Verteilung der Kühlleistungsdichte bzw. der von der Anordnung abgestrahlten Lichtstärkedichte möglich ist, wie aus Figur 1 ersichtlich.

In Figur 2 ist der Schnitt einer weiteren Ausführungsform einer erfindungsgemäßen Anordnung 1 schematisch dargestellt. Ähnliche Bauteile sind mit identischen Bezugszeichen wie in Figur 1 gekennzeichnet. Im Gegensatz zu Figur 1 ist die Verteilung der Kühlleistungsdichte des Kühlkörpers 7 invertiert zu der natürlichen Verteilung der Lichtstärkedichte des OLED-Elements festgelegt. Der Verlauf der Kühlleistungsdichte und der Verlauf der natürlichen Lichtstärkedichte kann jeweils entlang des Schnitts in Form einer Funktion dargestellt werden. Die erste Ableitung der beiden Funktionen ist vom Betrag her gleich, weist aber für die beiden Funktionen jeweils ein unterschiedliches Vorzeichen auf. Während die natürliche Lichtstärkedichte des OLED-Elements 2 somit in der Mitte des OLED-Elements 2 am niedrigsten ist, ist die Kühlleistungsdichte des Kühlkörpers 7 in der Mitte des OLED-Elements 2 am höchsten. Wie auch in dem Ausführungsbeispiel aus Figur 1 ist die Kühlleistungsdichte des Kühlkörpers 7 durch die Dicke des Kühlkörpers 7 festgelegt. In dem Ausführungsbeispiel nach Figur 2 umfasst die erfindungsgemäße Anordnung 1 ein OLED-Element 2, das bei einem Absenken seiner Temperatur unter die Umgebungstemperatur mehr Licht emittiert als bei der Umgebungstemperatur. Somit kompensieren sich Kühlleistungsdichte des Kühlkörpers 7 und natürliche Lichtstärkedichte des OLED-Elements 2 derart, dass die von der Anordnung 1 emittierte Lichtstärkedichte entlang der lateralen Erstreckung der Anordnung 1 konstant ist.

Anhand der in Figur 1 und Figur 2 beschriebenen Ausführungsbeispiele einer erfindungsgemäßen Anordnung 1 wird deutlich, dass die Verteilung der Lichtstärkedichte, die von der Anordnung 1 emittiert wird, über das Zusammenwirken von Kühlleistungsdichte des Kühlkörpers 7 und der natürlichen Verteilung der Lichtstärkedichte des von dem OLED-Element 2 emittierten Lichts bestimmt ist. Mit der erfindungsgemäßen Ausgestaltung einer Anordnung 1 lässt sich somit die Verteilung der Lichtstärkedichte des von Anordnung 1 emittierten Lichts, insbesondere eine homogene Verteilung der Lichtstärkedichte über die gesamte flächige Erstreckung der Anordnung 1, einfach und kostengünstig festlegen.

### Bezugszeichenliste

| | |
|---|---|
| 1 | Anordnung |
| 2 | OLED-Element |
| 3 | Vorderseite |
| 4 | Rückseite |
| 5 | erste Elektrode |
| 6 | zweite Elektrode |
| 7 | Kühlkörper |

## Patentansprüche

1. Anordnung (1) zum Erzeugen von Licht umfassend ein flächiges OLED-Element (2) mit einer Vorder- und einer Rückseite (3, 4), wobei an jeder der beiden Seiten (3, 4) flächige Elektroden (5, 6) angeordnet sind, von denen zumindest die an der Vorderseite (3) angeordnete transparent ist, wobei durch die Elektroden (5, 6) ein Strom erzeugbar ist, der zwischen den Elektroden (5, 6) flächig durch das OLED-Element (2) fließt, so dass das OLED-Element (2) Licht mit einer Lichtstärke emittiert, wobei das emittierte Licht zumindest an der Seite der Anordnung (1) aus der Anordnung (1) austritt, die der Vorderseite (3) des OLED-Elements (2) zugeordnet ist, **dadurch gekennzeichnet, dass** an einer der Seiten (3, 4) des OLED-Elements (2), insbesondere an der Rückseite (4) des OLED-Elements (2) ein flächiger Kühlkörper (7) angeordnet ist, der eine vorbestimmte Kühlleistungsdichte aufweist, wobei die Kühlleistungsdichte mit einer auf Flächensegmente des Kühlkörpers (7) bezogenen Verteilung festgelegt ist.

2. Anordnung (1) nach Anspruch 1, **dadurch gekennzeichnet, dass** jedem Flächensegment des Kühlkörpers (7) jeweils ein Flächensegment des OLED-Elements (2) zugeordnet ist.

3. Anordnung (1) nach Anspruch 1 oder 2, **dadurch gekennzeichnet, dass** der Kühlkörper (7) an der Rückseite (4) angeordnet ist, wobei die an der Rückseite (4) angeordnete Elektrode (6) und der Kühlkörper (7) transparent sind.

4. Anordnung (1) nach einem der vorangehenden Ansprüche,
**dadurch gekennzeichnet, dass** an der Vorderseite (3) ein zweiter transparenter Kühlkörper (7) angeordnet ist.

5. Anordnung (1) nach einem der vorangehenden Ansprüche,
**dadurch gekennzeichnet, dass** die Verteilung der Kühlleistungsdichte zumindest eines der Kühlkörper (7) so festgelegt ist, dass die Kühlleistungsdichte in Flächensegmenten in und/oder nahe der Flächenmitte des OLED-Elements (2) höher ist als in Flächensegmenten am Rand des OLED-Elements (2).

6. Anordnung (1) nach einem der Ansprüche 1 bis 4, **dadurch gekennzeichnet**, das die Verteilung der Kühlleistungsdichte zumindest eines der Kühlkörper (7) so festgelegt ist, dass die Kühlleistungsdichte in Flächensegmenten in und/oder nahe der Flächenmitte des OLED-Elements (2) niedriger ist als in Flächensegmenten am Rand des OLED-Elements (2).

7. Anordnung (1) nach einem der vorangehenden Ansprüche, **dadurch gekennzeichnet, dass** die Verteilung der Kühlleistungsdichte zumindest eines der Kühlkörper (7) in Abhängigkeit von der auf Flächensegmente des OLED-Elements (2) bezogenen natürlichen Verteilung der Lichtstärkedichte des von dem OLED-Element (2) emittierten Lichts festgelegt ist, wobei ein Flächensegment des Kühlkörpers (7) jeweils einem Flächensegment des OLED-Elements (2) zugeordnet ist.

8. Anordnung (1) nach Anspruch 7, **dadurch gekennzeichnet, dass** die Verteilung der Kühlleistungsdichte des Kühlkörpers (7) invertiert zu der natürlichen Verteilung der Lichtstärkedichte des OLED-Elements (2) festgelegt ist.

9. Anordnung (1) nach Anspruch 7, **dadurch gekennzeichnet, dass** die Verteilung der Kühlleistungsdichte des Kühlkörpers (7) direkt korrelierend zu der natürlichen Verteilung der Lichtstärkedichte des OLED-Elements (2) festgelegt ist.

10. Anordnung (1) nach einem der vorangehenden Ansprüche, **dadurch gekennzeichnet, dass** die Kühlleistungsdichte des Kühlkörpers (7) durch die Dicke des flächigen Kühlkörpers (7) festgelegt ist.

11. Leuchte umfassend eine Anordnung (1) nach einem der vorangehenden Ansprüche.
